# FASCICULE DE BREVET EUROPEEN

(11) **EP 2 706 676 B1**
(45) Date de publication et mention de la délivrance du brevet: **01.04.2015**
(21) Numéro de dépôt: 13182555.6
(22) Date de dépôt: 02.09.2013
(51) Int. Cl.: H04B 7/185

(54) **Méthode de caractérisation d'une antenne de transmission d'un satellite en orbite et système associé.**
Verfahren zur Kennzeichnung einer Übertragungsantenne eines Satelliten auf seiner Umlaufsbahn und Anordnung dafür.
Method for charaterizing a transmission antenna of a satellite on orbit and system therefor.

(30) Priorité: 07.09.2012 FR 1202393
(43) Date de publication de la demande: 12.03.2014
(73) Titulaire: Thales, 92200 Neuilly Sur Seine (FR)
(72) Inventeur: Tessandori, Stéphane, 06150 Cannes La Bocca (FR)
(74) Mandataire: Hammes, Pierre

(56) Documents cités:
- WO-A1-2010/092421
- US-A- 5 697 050
- US-A1- 2009 298 422
- US-B1- 6 989 786

## Description

L'invention concerne une méthode et un système de test de la charge utile d'un satellite en orbite. Plus précisément l'invention concerne la caractérisation de l'antenne de transmission d'un satellite en orbite.

Le domaine de l'invention est celui des méthodes et systèmes permettant de tester le fonctionnement nominal d'une antenne de transmission d'un satellite en orbite, c'est-à-dire de caractériser le diagramme de rayonnement de l'antenne et de le comparer à des spécifications de fonctionnement attendu.

L'invention s'applique notamment pour le test en orbite d'un satellite de télécommunication mais également de tout satellite dont la charge utile est composée d'au moins un répéteur et d'une antenne de transmission vers une liaison descendante.

Les méthodes connues de test de la charge utile d'un satellite en orbite sont le plus souvent basées sur l'emploi d'un signal de test sur porteuse non modulée qui est généré et transmis sur la liaison montante du satellite en orbite par une station sol couplée au dispositif de test. Le satellite réceptionne ce signal de test via une antenne de réception, le signal est propagé à travers un répéteur et retransmit à la station sol via une antenne de transmission. A partir de mesures réalisées sur le signal transmis sur la liaison descendante du satellite, il est possible de caractériser la réponse de l'antenne de transmission du satellite.

Les inconvénients des méthodes de test basées sur l'emploi de signaux de test spécifiques sont multiples.

Le test de l'antenne de transmission est limité à une partie de la zone de couverture de l'antenne de réception. En effet, pour que la méthode de test puisse être mise en oeuvre, la station sol, qui opère à la fois la transmission du signal de test sur la liaison montante et l'acquisition du signal retransmis par le satellite sur la liaison descendante, doit être positionnée dans la zone d'intersection des zones de couverture de l'antenne de réception et de l'antenne de transmission du satellite. Ainsi, il n'est pas possible de tester l'antenne de transmission dans toute sa couverture angulaire.

En outre, l'extraction de la seule contribution de l'antenne de transmission nécessite la mise en oeuvre d'une boucle automatique de gain pour compenser les variations de gain de l'antenne de réception. Cette boucle assure un niveau constant à l'interface d'entrée de l'antenne de transmission, ce qui permet de mesurer au sol uniquement les variations de l'antenne de transmission. Cependant, le diagramme de rayonnement de l'antenne de réception étant généralement plus directif que celui de l'antenne de transmission, il en résulte que la dynamique de mesure sous test de l'antenne de transmission est limitée à la dynamique disponible dans la boucle de contrôle automatique de gain.

De plus, les mesures d'isolation, c'est-à-dire la caractérisation de l'antenne de transmission pour des zones de couverture pour lesquelles le gain de l'antenne est très faible, sont également limitées par le niveau de réception faible sur l'antenne de réception.

Un autre problème lié à l'emploi de signaux de test est que lorsqu'on souhaite tester le fonctionnement d'une antenne de transmission multifaisceaux ou d'une antenne de transmission à plusieurs fréquences, cela nécessite la génération de signaux de test multi-porteuses et donc d'un dispositif de génération de tels signaux, ce qui accroit la complexité du système de test.

Enfin, la génération d'une porteuse de test peut interférer avec d'autres satellites adjacents ce qui nécessite une coordination globale en fréquence.

Voir US-A-5 697 050 (Wiedeman).

La présente invention propose une méthode et un système qui permettent de caractériser l'antenne de transmission d'un satellite en orbite dans toute sa dynamique et toute sa zone de couverture, indépendamment des caractéristiques de l'antenne de réception.

L'invention ne nécessite pas l'emploi de signaux de test sur porteuse non modulée et donc permet de supprimer les inconvénients liés à leur utilisation.

En outre, l'invention permet de tester l'antenne de transmission d'un satellite à plusieurs faisceaux et/ou à plusieurs fréquences distinctes sans nécessiter de modifier les équipements de test et ainsi d'augmenter la complexité.

L'invention a ainsi pour objet une méthode de caractérisation d'une antenne de transmission d'un satellite en orbite comprenant une charge utile comprenant des moyens d'amplification de signal, ladite méthode consistant à:
- Configurer lesdits moyens d'amplification pour générer un bruit thermique en entrée de l'antenne de transmission,
- Acquérir, au moyen d'une station au sol, le signal transmis par l'antenne de transmission sur la liaison descendante du satellite pendant une durée prédéterminée,
- Pendant ladite durée prédéterminée, commander ledit satellite en orbite pour lui imprimer un biais angulaire de variation prédéterminée et enregistrer cette variation,
- Corréler la mesure du signal transmis sur la liaison descendante et la variation de biais angulaire du satellite pour en déduire les variations de gain de l'antenne de transmission en fonction du biais angulaire du satellite.

Avantageusement, les moyens d'amplification sont configurés pour fonctionner à saturation.

Les moyens d'amplification peuvent également comporter un premier moyen d'amplification intermédiaire et un second moyen d'amplification haute puissance, ledit moyen d'amplification intermédiaire étant configuré pour amplifier le signal à un niveau prédéterminé en entrée du second moyen d'amplification haute puissance, ledit niveau étant déterminé de sorte que le niveau du signal de sortie du second moyen d'amplification haute puissance est supérieur au niveau de bruit généré par l'antenne de la station au sol.

Selon un mode particulier de réalisation de l'invention, la charge utile comporte au moins une antenne de réception et une voie de réception et dans laquelle la voie de réception est déconnectée de l'antenne de réception pour limiter l'influence du bruit issu de la liaison montante du satellite.

L'invention a également pour objet un système pour la caractérisation d'une antenne de transmission d'un satellite en orbite comprenant une charge utile comprenant des moyens d'amplification de signal, ledit système comprenant :
- Des moyens de configuration desdits moyens d'amplification pour générer un bruit thermique en entrée de l'antenne de transmission,
- Des moyens d'acquisition du signal transmis par l'antenne de transmission sur la liaison descendante du satellite pendant une durée prédéterminée,
- Des moyens de commande du satellite en orbite, pendant ladite durée prédéterminée, pour lui imprimer un biais angulaire de variation prédéterminée et des moyens d'enregistrement de cette variation,
- Des moyens pour corréler la mesure du signal transmis sur la liaison descendante et la variation de biais angulaire du satellite afin d'en déduire les variations de gain de l'antenne de transmission en fonction du biais angulaire du satellite.

D'autres caractéristiques et avantages de la présente invention apparaîtront mieux à la lecture de la description qui suit en relation aux dessins annexés qui représentent :
- La figure 1, un synoptique illustrant une méthode de test de l'antenne de transmission d'un satellite en orbite selon l'art antérieur,
- La figure 2, un diagramme illustrant la limitation, induite par la méthode de test décrite à la figure 1, sur la dynamique angulaire de dépointage de l'antenne de transmission qui peut être testée,
- La figure 3, un synoptique illustrant certains inconvénients de la méthode de test décrite à la figure 1,
- La figure 4, un synoptique illustrant la méthode de test selon l'invention,
- La figure 5, un schéma de la charge utile d'un satellite à tester et en particulier de la chaine d'amplification à bord,
- La figure 6a, un diagramme du gain du signal mesuré sur la liaison descendante du satellite en fonction du temps,
- La figure 6b, un diagramme du biais angulaire imprimé par le satellite pendant l'acquisition du signal sur la liaison descendante en fonction du même intervalle de temps qu'à la figure 6a,
- La figure 6c, une illustration d'un exemple du diagramme d'antenne obtenu en combinant les mesures illustrées aux figures 6a et 6b,
- La figure 6d, une illustration de la comparaison du diagramme d'antenne obtenu avec les spécifications de l'antenne de transmission du satellite.

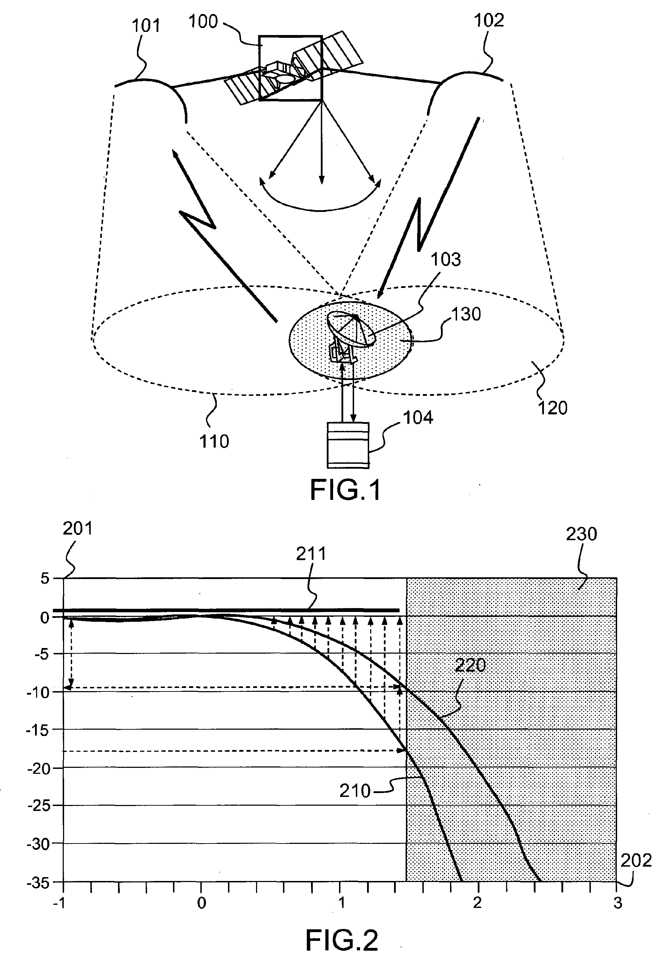

Les figures 1,2 et 3 illustrent sur plusieurs schémas et diagrammes, le principe d'une méthode connue de test de l'antenne de transmission d'un satellite en orbite ainsi que ses inconvénients comme déjà évoqué dans la partie introductive de la présente demande.

La figure 1 illustre, sur un schéma, le principe d'une méthode connue de test de l'antenne de transmission 102 d'un satellite 100 en orbite.

Une station de test 104, couplée à une antenne 103, est utilisée pour générer un signal de test sur porteuse non modulée et le transmettre sur la liaison montante du satellite 100. Le signal de test est reçu par l'antenne de réception 101 du satellite 100 puis retransmis par l'antenne de transmission 102 du satellite 100 via la liaison descendante. Le signal est reçu par l'antenne 103 de la station de test 104 qui effectue sur celui-ci des mesures permettant de caractériser le diagramme d'antenne de l'antenne de transmission 102.

Comme explicité ci-dessus, un inconvénient de cette méthode est que la zone de couverture testable est limitée à la zone d'intersection 130 entre la zone de couverture 110 de l'antenne de réception 101 et la zone de couverture 120 de l'antenne de transmission 102.

La figure 2 représente, sur un diagramme, le gain d'antenne relatif 201, exprimé en décibels, en fonction du biais angulaire 202 imprimé par le satellite par rapport à une direction de pointage de référence. Sur le diagramme de la figure 2 sont représentées les courbes de gain respectives de l'antenne de réception 210 et de l'antenne de transmission 220 du satellite. L'antenne de réception est en général plus directive que l'antenne de transmission ce qui engendre une atténuation plus rapide du gain d'antenne lorsque le biais angulaire augmente.

Pour compenser les variations du gain de l'antenne de réception, une boucle de contrôle automatique de gain est actionnée dans la charge utile du satellite afin de ramener le signal en entrée de l'antenne de transmission à un niveau constant 211. De cette façon, la station sol peut mesurer sur le signal reçu via la voie descendante uniquement les variations du gain de l'antenne de transmission.

La boucle de contrôle automatique de gain présente une dynamique de fonctionnement d'entrée limitée. Dans l'exemple de la figure 2, elle ne fonctionne que jusqu'à un niveau d'entrée de l'ordre de -20 dB. Ainsi, pour des biais angulaires supérieurs à une valeur donnée, de l'ordre de 1.5° sur l'exemple de la figure 2, les variations du gain de l'antenne de réception ne sont plus compensées ce qui implique que les excursions angulaires 230 au delà d'un certain seuil ne peuvent pas être testées.

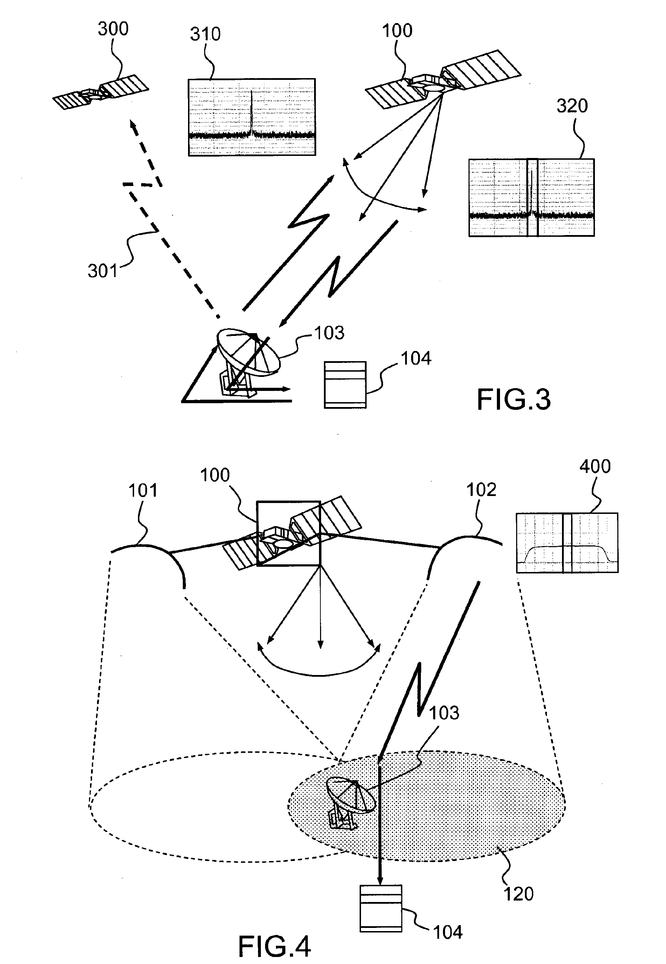

La figure 3 illustre la nécessité d'un plan de coordination de fréquence pour la liaison montante du satellite sous test 100. Un signal de test sur porteuse non modulée 310 est émis par l'antenne 103 de la station de test 104 sur la liaison montante du satellite 100. En réception, la station de test 104 récupère, par filtrage, la porteuse non modulée retransmise sur la liaison descendante du satellite 100.

L'émission d'une porteuse non modulée 310 sur la liaison montante peut engendrer des interférences 301 sur un ou plusieurs satellites adjacents 300. Ainsi, un plan de coordination de fréquence est nécessaire pour éviter de perturber des fréquences par ailleurs exploitées par d'autres satellites.

La figure 4 illustre la mise en oeuvre de la méthode selon l'invention permettant de caractériser l'antenne de transmission 102 d'un satellite en orbite 100 sans générer ni transmettre de signal de test sur la liaison montante du satellite.

La méthode selon l'invention consiste à générer, à bord de la charge utile du satellite, un bruit thermique de puissance suffisante pour assurer à l'interface d'entrée de l'antenne de transmission 102, la présence d'un bruit large bande de niveau sensiblement constant et indépendant des excursions angulaires du satellite. De cette façon, le signal transmis par l'antenne de transmission 102 sur la liaison descendante est acquis par l'antenne 103 de la station de test 104 puis analysé pour caractériser le gain d'antenne dans toute la zone de couverture 120 qui n'est plus limitée à l'intersection avec la zone de couverture de l'antenne de réception 101.

Le bruit 400 généré à l'interface d'entrée de l'antenne 102 est filtré par la station de test 104 dans une bande d'analyse fréquentielle prédéterminée.

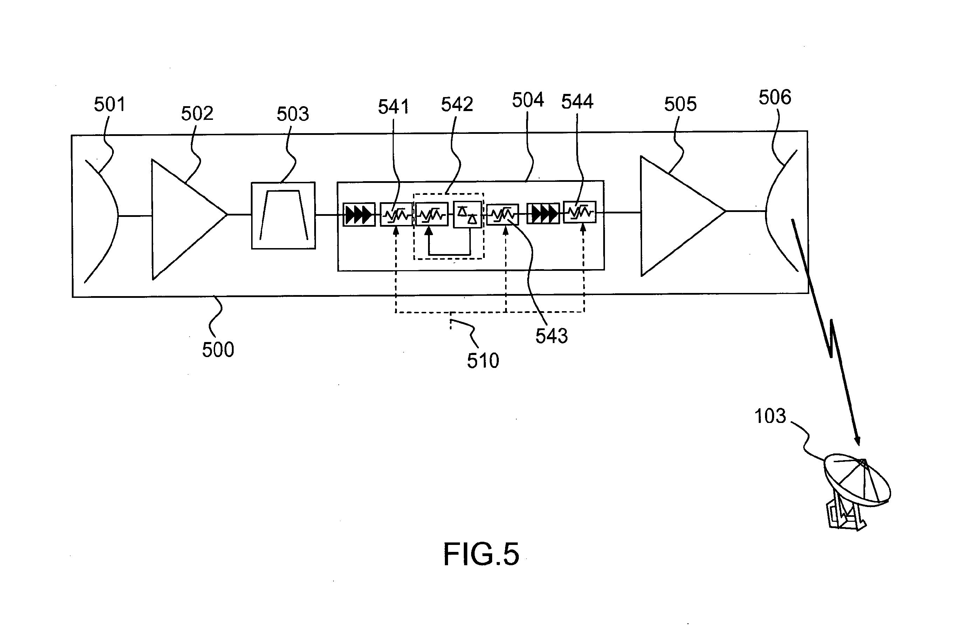

La figure 5 représente, sur un schéma simplifié, un exemple de charge utile 500 d'un satellite qui comporte une antenne de réception 501, une voie de réception 502, un filtre de canal 503, une chaine d'amplification intermédiaire 504, un amplificateur haute puissance 505 et une antenne de transmission 506. La charge utile 500 ainsi constituée réalise une fonction de répéteur, c'est-à-dire que le signal reçu sur la voie de réception 502 est retransmis sur la liaison descendante du satellite via l'antenne de transmission 506. Sur l'exemple de la figure 5, un seul répéteur est représenté, mais une charge utile peut contenir plusieurs répéteurs associés à plusieurs fréquences de réception et/ou d'émission différentes.

Lorsqu'aucun signal n'est reçu par l'antenne de réception 501, la charge utile 500 génère cependant un bruit qui présente deux composantes principales, une première composante de bruit issu du rayonnement de la Terre, transmis à la charge utile par l'antenne de réception 501 et contenant potentiellement des interférences issues des systèmes satellites adjacents, et une seconde composante de bruit thermique généré par le répéteur lui même, en particulier par la chaîne de réception 502.

En configurant 510 la chaine d'amplification intermédiaire 504 de sorte à la faire fonctionner en saturation et ainsi provoquer la saturation de l'amplificateur haute puissance 505, il est possible d'obtenir un niveau de bruit suffisant à l'interface d'entrée de l'antenne de transmission 506 pour pouvoir caractériser son diagramme d'antenne. Le niveau de bruit généré en sortie de l'amplificateur haute puissance 505 doit être supérieur au niveau de bruit généré par l'antenne 103 de la station de test au sol.

On décrit à présent plus en détail un exemple de réalisation de la chaine d'amplification intermédiaire 504 et la configuration associée pour obtenir l'effet souhaité pour permettre la caractérisation de l'antenne de transmission 506.

La chaine d'amplification 504 comporte au moins un premier amplificateur 541 qui permet d'ajuster le niveau de signal en sortie du filtre de canal 503 pour qu'il soit compatible de la dynamique de la boucle de contrôle automatique de gain 542 placée en sortie du premier amplificateur 541. La boucle de contrôle automatique de gain 542 permet d'obtenir un signal de niveau constant en entrée d'un second amplificateur 543 qui est apte à amplifier le signal pour atteindre le point de fonctionnement souhaité en entrée de l'amplificateur haute puissance 505. Un troisième amplificateur 544 est présent en sortie du deuxième amplificateur 543 pour compenser les non linéarités de l'amplificateur haute puissance 505.

L'exemple de chaine d'amplification 504 décrit à la figure 5 est donné à titre illustratif et non limitatif. En particulier d'autres amplificateurs agencés en cascade peuvent être inclus. Par exemple la boucle de contrôle automatique de gain 542 peut être optionnelle.

Pour obtenir un niveau de bruit suffisant en entrée de l'antenne de transmission 506, les premier et second amplificateurs 541,543 sont configurés pour amplifier le signal d'entrée avec un gain maximum avec l'objectif d'atteindre un fonctionnement en saturation. Le troisième amplificateur 544 est configuré pour obtenir la saturation de l'amplificateur haute puissance ou pour obtenir un niveau opérationnel suffisant qui dépend du bilan de liaison de l'antenne de transmission et du bilan de liaison de l'antenne de la station sol 103. Le niveau de bruit ainsi généré présente également une forte stabilité temporelle ce qui permet de réaliser une acquisition du signal sur la voie descendante pendant une durée suffisante pour réaliser les mesures nécessaires à la caractérisation de l'antenne de transmission 506.

Dans une variante de réalisation de l'invention, la voie de réception 502 de la charge utile peut être déconnectée de l'antenne de réception 501 du satellite, par exemple en reliant son entrée à l'entrée d'une autre voie de réception (non représentée). De cette façon, le bruit reçu par l'antenne de réception 501 est supprimé et seul le bruit thermique généré par le répéteur lui-même est utilisé.

L'utilisation de la chaine d'amplification de la charge utile dans un fonctionnement en saturation permet de remplacer le signal de test habituellement généré sur la voie montante du satellite. De cette façon, la méthode de test ne nécessite aucun signal spécifique et ne dépend pas des caractéristiques et du fonctionnement de l'antenne de réception 501 du satellite.

La méthode de test selon l'invention consiste en l'exécution des étapes suivantes.

La station de test 104, qui comporte des moyens d'acquisition du signal émis sur la voie descendante du satellite et des moyens de mesure et d'analyse spectrale de ce signal, est connectée sur la voie descendante du satellite.

La chaine d'amplification intermédiaire 504 à bord de la charge utile du satellite est configurée pour amplifier le bruit du répéteur de sorte à atteindre un niveau de saturation de l'amplificateur haute puissance 505 ou un niveau de bruit opérationnel suffisant à l'interface d'entrée de l'antenne de transmission 506. La configuration de la charge utile du satellite est réalisée par un centre de contrôle du satellite déporté de la station de test.

L'analyse spectrale du signal est par exemple réalisée par un analyseur de spectre configuré pour réaliser un filtrage passe-bas du signal reçu afin de lisser le niveau du signal en supprimant les composantes hautes fréquences. Plusieurs points de mesure successifs sont réalisés au cours d'un balayage temporel.

En outre, un biais angulaire est imprimé au satellite par rapport à sa direction de pointage de référence, afin de permettre la caractérisation de l'antenne dans toute sa zone de couverture et d'observer les variations du gain de l'antenne en fonction du temps. La commande de pointage du satellite est également réalisée depuis un centre de contrôle déporté via une liaison de télécommande et télémétrie.

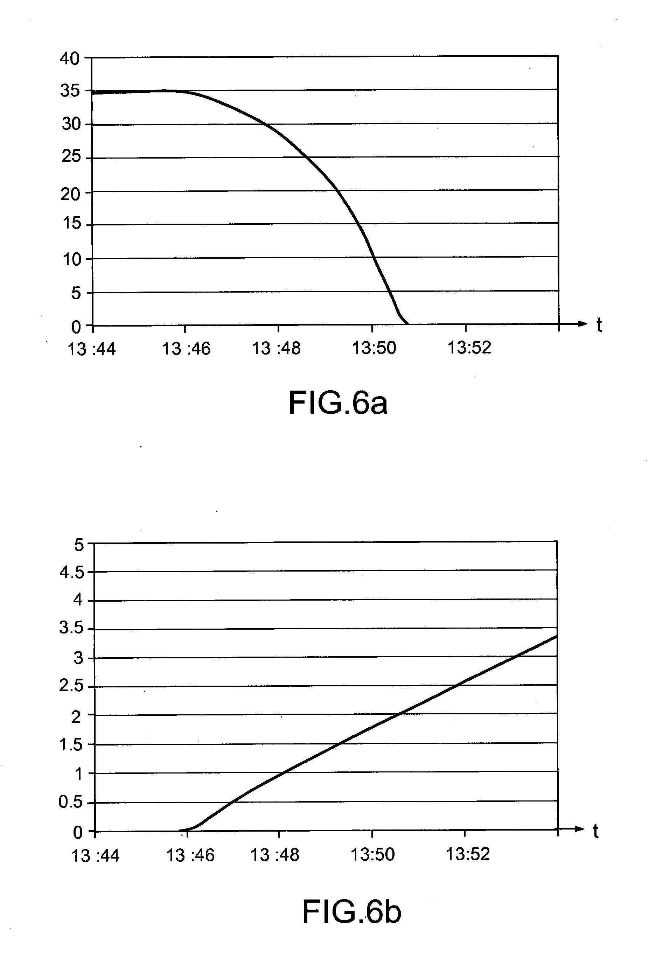

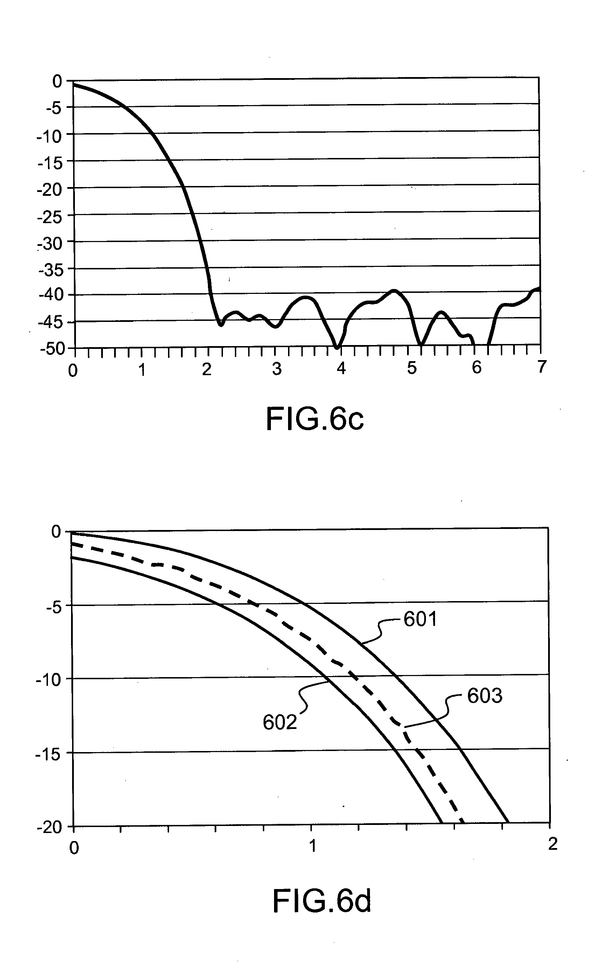

Des moyens de traitement du signal acquis par la station de test 104, qui peuvent être inclus dans la station de test ou déportés, sont ensuite exécutés pour produire une mesure du diagramme de l'antenne de transmission du satellite. Les figures 6a,6b,6c,6d illustrent les traitements effectués sur le signal acquis.

La figure 6a représente, sur un diagramme, la mesure du niveau du signal acquis par la station de test, en décibels de milliWatt (dBm), en fonction du temps t.

La figure 6b représente, sur la même échelle de temps que la figure 6a, la variation du biais angulaire, exprimé en degrés, de la direction de pointage du satellite.

En corrélant les diagrammes des figures 6a et 6b, on obtient le diagramme de la figure 6c qui donne le niveau du signal acquis en fonction du biais angulaire imprimé au satellite.

La figure 6d illustre, la dernière étape de la méthode selon l'invention, consistant à comparer les variations du gain d'antenne 603 reconstitué sur une plage de variation angulaire donnée avec un gabarit spécifié du diagramme de l'antenne de transmission du satellite. Un tel gabarit consiste par exemple en une courbe de gain maximum 601 et une courbe de gain minimum 602 entre lesquelles le gain mesuré doit varier.

## Revendications

1. Méthode de caractérisation d'une antenne de transmission (102,506) d'un satellite en orbite (100) comprenant une charge utile (500) comprenant des moyens d'amplification de signal (504,505), ladite méthode étant **caractérisée en ce qu**'elle consiste à :
- Configurer lesdits moyens d'amplification (504,505) pour générer un bruit thermique en entrée de l'antenne de transmission (102,506),
- Acquérir, au moyen d'une station au sol (103,104), le signal transmis par l'antenne de transmission (102,506) sur la liaison descendante du satellite (100) pendant une durée prédéterminée,
- Pendant ladite durée prédéterminée, commander ledit satellite en orbite (100) pour lui imprimer un biais angulaire de variation prédéterminée et enregistrer cette variation,
- Corréler la mesure du signal transmis sur la liaison descendante et la variation de biais angulaire du satellite pour en déduire les variations de gain de l'antenne de transmission (102,506) en fonction du biais angulaire du satellite.

2. Méthode de caractérisation selon la revendication 1 dans laquelle la lesdits moyens d'amplification (504,505) sont configurés pour fonctionner à saturation.

3. Méthode de caractérisation selon la revendication 1 dans laquelle lesdits moyens d'amplification (504,505) comportent un premier moyen d'amplification intermédiaire (504) et un second moyen d'amplification haute puissance (505), ledit moyen d'amplification intermédiaire (504) étant configuré pour amplifier le signal à un niveau prédéterminé en entrée du second moyen d'amplification haute puissance (505), ledit niveau étant déterminé de sorte que le niveau du signal de sortie du second moyen d'amplification haute puissance (505) est supérieur au niveau de bruit généré par l'antenne (103) de la station au sol.

4. Méthode de caractérisation selon l'une des revendications précédentes dans laquelle la charge utile (500) comporte au moins une antenne de réception (501) et une voie de réception (502) et dans laquelle la voie de réception (502) est déconnectée de l'antenne de réception (501) pour limiter l'influence du bruit issu de la liaison montante du satellite.

5. Système pour la caractérisation d'une antenne de transmission (102,506) d'un satellite en orbite (100) comprenant une charge utile (500) comprenant des moyens d'amplification de signal (504,505), ledit système comprenant :
- Des moyens de configuration desdits moyens d'amplification (504,505) pour générer un bruit thermique en entrée de l'antenne de transmission (102,506),
- Des moyens d'acquisition (103,104) du signal transmis par l'antenne de transmission (102,506) sur la liaison descendante du satellite (100) pendant une durée prédéterminée,
- Des moyens de commande du satellite en orbite (100), pendant ladite durée prédéterminée, pour lui imprimer un biais angulaire de variation prédéterminée et des moyens d'enregistrement de cette variation,
- Des moyens pour corréler la mesure du signal transmis sur la liaison descendante et la variation de biais angulaire du satellite afin d'en déduire les variations de gain de l'antenne de transmission (102,506) en fonction du biais angulaire du satellite.

## Patentansprüche

1. Verfahren zum Charakterisieren einer Sendeantenne (102, 506) eines Satelliten im Orbit (100), der eine Nutzlast (500) umfasst, die Signalverstärkungsmittel (504, 505) umfasst, wobei das Verfahren **dadurch gekennzeichnet** ist, dass es Folgendes beinhaltet:
- Konfigurieren der Verstärkungsmittel (504, 505) zum Erzeugen von thermischem Rauschen am Eingang der Sendeantenne (102, 506);
- Erfassen, mittels einer Bodenstation (103, 104), des von der Sendeantenne (102, 506) auf der Downlink des Satelliten (100) für eine vorbestimmte Dauer gesendeten Signals;
- Steuern des Satelliten im Orbit (100) während der vorbestimmten Dauer, um ihm eine Schrägung mit vorbestimmter Variation zu übermitteln, und Aufzeichnen dieser Variation;
- Korrelieren des Messwertes des auf der Downlink gesendeten Signals und der Schrägungsvariation des Satelliten, um die Gewinnvariationen der Sendeantenne (102, 506) in Abhängigkeit von der Schrägung des Satelliten davon abzuleiten.

2. Charakterisierungsverfahren nach Anspruch 1, wobei die Verstärkungsmittel (504, 505) so konfiguriert sind, dass sie bis zur Sättigung arbeiten.

3. Charakterisierungsverfahren nach Anspruch 1, wobei die Verstärkungsmittel (504, 505) ein erstes Zwischenverstärkungsmittel (504) und ein zweites Hochleistungsverstärkungsmittel (505) umfassen, wobei das Zwischenverstärkungsmittel (504) zum Verstärken des Signals auf einen vorbestimmten Pegel am Eingang des zweiten Hochleistungsverstärkungsmittels (505) konfiguriert ist, wobei der Pegel so bestimmt wird, dass der Pegel des Ausgangssignals des zweiten Hochleistungsverstärkungsmittels (505) größer ist als der von der Antenne der Bodenstation (103) erzeugte Rauschpegel.

4. Charakterisierungsverfahren nach einem der vorherigen Ansprüche, wobei die Nutzlast (500) wenigstens eine Empfangsantenne (501) und einen Empfangskanal (502) umfasst und wobei der Empfangskanal (502) von der Empfangsantenne (501) abgetrennt wird, um den Einfluss des von der Uplink des Satelliten kommenden Rauschens zu begrenzen.

5. System zum Charakterisieren einer Sendeantenne (102, 506) eines Satelliten im Orbit (100), der eine Nutzlast (500) umfasst, die Signalverstärkungsmittel (504, 505) umfasst, wobei das System Folgendes umfasst:
- Mittel zum Konfigurierten der Verstärkungsmittel (504, 505), um thermisches Rauschen am Eingang der Sendeantenne (102, 506) zu erzeugen;
- Mittel (103, 104) zum Erfassen des von der Sendeantenne (102, 506) auf der Downlink des Satelliten (100) für eine bestimmte Dauer gesendeten Signals;
- Mittel zum Steuern des Satelliten im Orbit (100) während der vorbestimmten Dauer, um eine Schrägung von vorbestimmter Variation zu dem Satelliten zu übermitteln, und Mittel zum Aufzeichnen dieser Variation;
- Mittel zum Korrelieren der Messung des auf der Downlink gesendeten Signals und der Schrägungsvaiiation des Satelliten, um die Gewinnvaiiationen der Sendeantenne (102, 506) in Abhängigkeit von der Schrägung des Satelliten davon abzuleiten.

## Claims

1. A method for characterising a transmission antenna (102, 506) of a satellite in orbit (100) comprising a payload (500) that comprises signal amplification means (504, 505), said method being **characterised in that** it comprises:
- configuiing said amplification means (504, 505) to generate thermal noise at the input of said transmission antenna (102, 506);
- acquiring, by means of a ground station (103, 104), the signal transmitted by said transmission antenna (102, 506) on the downlink of said satellite (100) for a predetermined duration;
- controlling said satellite in orbit (100), during said predetermined duration, so as to impose an angular bias of predetermined variation to said satellite, and logging said variation;
- correlating the measurement of the signal transmitted on the downlink and the variation of angular bias of said satellite so as to deduce the gain variations of said transmission antenna (102, 506) as a function of the angular bias of said satellite.

2. The characterisation method according to claim 1, wherein said amplification means (504, 505) are configured to operate to saturation.

3. The characterisation method according to claim 1, wherein said amplification means (504, 505) comprise a first intermediate amplification means (504) and a second high-power amplification means (505), said intermediate amplification means (504) being configured to amplify the signal to a predetermined level at the input of said second high-power amplification means (505), said level being determined so that the level of the output signal of said second high-power amplification means (505) is higher than the noise level generated by the antenna of said ground station (103).

4. The characterisation method according to any one of the preceding claims, wherein said payload (500) comprises at least one reception antenna (501) and one reception channel (502) and wherein said reception channel (502) is disconnected from said reception antenna (501) so as to limit the influence of the noise coming from the uplink of said satellite.

5. A system for characterising a transmission antenna (102, 506) of a satellite in orbit (100) comprising a payload (500) that comprises signal amplification means (504, 505), said system comprising:
- means for configuring said amplification means (504, 505) so as to generate thermal noise at the input of said transmission antenna (102, 506);
- means (103, 104) for acquiring the signal transmitted by said transmission antenna (102, 506) on the downlink of said satellite (100) for a predetermined duration;
- means for controlling said satellite in orbit (100), during said predetermined duration, so as to impose an angular bias of predetermined variation to said satellite, and means for logging said variation;
- means for correlating the measurement of the signal transmitted on the downlink and the variation of angular bias of said satellite so as to deduce the gain variations of said transmission antenna (102, 506) as a function of the angular bias of said satellite.
